# EUROPEAN PATENT APPLICATION

(11) **EP 2 768 021 A2**
(43) Date of publication of application: **20.08.2014**
(21) Application number: 13159419.4
(22) Date of filing: 15.03.2013
(51) Int. Cl.: H01L 27/08, H01L 29/78

(54) **Rectifier circuit and power source circuit**

(30) Priority: 15.02.2013 JP 2013027715
(71) Applicant: Toshiba Lighting & Technology Corporation, Yokosuka-shi Kanagawa 237-8510 (JP)
(72) Inventor: Otake, Hirokazu, Kanagawa 237-8510 (JP); Kitamura, Noriyuki, Kanagawa 237-8510 (JP); Takahashi, Yuji, Kanagawa 237-8510 (JP); Akahoshi, Hiroshi, Kanagawa 237-8510 (JP)
(74) Representative: Bokinge, Ole

(57) **Abstract**

According to an embodiment, a rectifier circuit includes a first diode, a switching element, and a second diode. The first diode is connected between a first terminal and a second terminal so that a direction toward the first terminal from the second terminal is in a forward direction. The switching element has a first main electrode connected to the first terminal, a second main electrode connected to a cathode of the first diode, and a gate electrode connected to an anode of the first diode. The second diode is connected in parallel with respect to the switching element so that a direction toward the first terminal from the cathode of the first diode is in a forward direction, between the first main electrode and the second main electrode of the switching element.

## Description

### FIELD

Embodiments described herein relate generally to a rectifier circuit.

### BACKGROUND

A rectifier circuit, in which a unipolar type field effect transistor (FET) serving as a normally-on device and a diode are cascode-connected to each other, has been suggested. A switching speed of the rectifier circuit depends on the diode, and pressure resistance ability of the device depends on the FET.

For example, when using such a rectifier circuit in a flywheel diode of a switching power source operating at high speed, in some cases, a delay may occur in the turn-on, due to capacity parasitizing between a gate and a source of the FET.

### DESCRIPTION OF THE DRAWINGS

FIGS. 1A and 1B are circuit diagrams of a rectifier circuit of an embodiment.
FIG. 2 is a circuit diagram of a power source circuit of the embodiment.
FIGS. 3A and 3B are timing charts that illustrate an operation of the power source circuit of the embodiment.
FIGS. 4A to 4F are timing charts that illustrate the operation of the rectifier circuit of the embodiment.
FIGS. 5A and 5B are circuit diagrams of a power source circuit of another specific example of the embodiment.
FIG. 6 is a circuit diagram of a power source circuit of another specific example of the embodiment.

### DETAILED DESCRIPTION

According to an embodiment, a rectifier circuit includes a first diode, a switching element, and a second diode. The first diode is connected between a first terminal and a second terminal so that a direction toward the first terminal from the second terminal is in a forward direction. The switching element has a first main electrode connected to the first terminal, a second main electrode connected to a cathode of the first diode, and a gate electrode connected to an anode of the first diode. The second diode is connected in parallel with respect to the switching element so that a direction toward the first terminal from the cathode of the first diode is in a forward direction, between the first main electrode and the second main electrode of the switching element.

Hereinafter, the embodiment will be described referring to the drawings. In addition, in the respective drawings, the same elements are denoted by the same reference numerals.

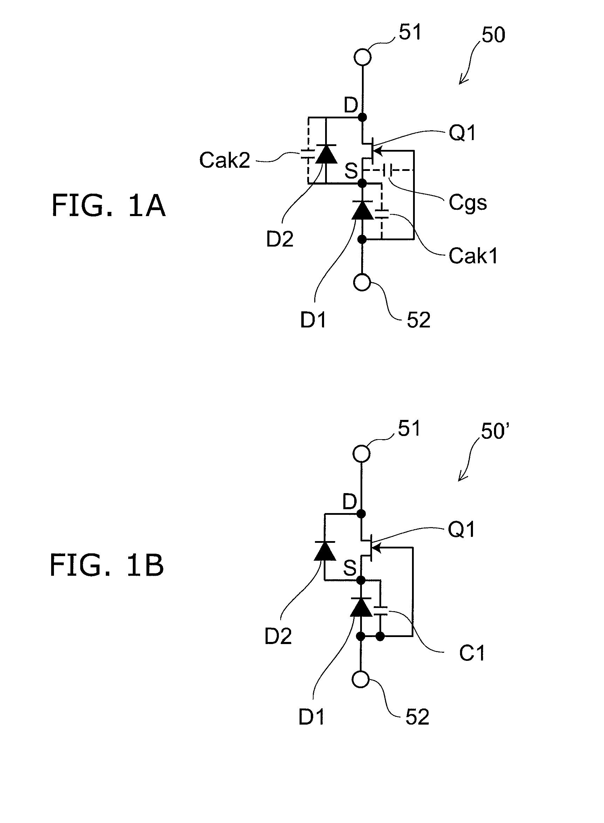

FIG. 1A is a circuit diagram of a rectifier circuit 50 of the embodiment.

The rectifier circuit 50 of the embodiment has a switching element Q1 and a first diode D1 that are connected between a first terminal 51 and a second terminal 52. The switching element Q1 and the first diode D1 are cascode-connected between the first terminal 51 and the second terminal 52.

The first terminal 51 functions as a cathode terminal in the rectifier circuit 50, and the second terminal 52 functions as an anode terminal in the rectifier circuit 50.

The switching element Q1 is a uniplolar type Field effect transistor (FET), and has a drain electrode as the first main electrode, a source electrode as the second main electrode, and a gate electrode.

The switching element Q1 is a normally-on type element that is turned on in a state where the control electric potential is not given to the gate electrode. For example, it is possible to use a high electron mobility transistor (HEMT) using a material having a band gap that is greater than silicon, as the switching element Q1.

The first diode D1 is connected between the first terminal 51 and the second terminal 52 so that a direction toward the first terminal 51 from the second terminal 52 is in a forward direction. The anode of the first diode D1 is connected to the second terminal 52. The cathode of the first diode D1 is connected to the source electrode of the switching element Q1.

The drain electrode of the switching element Q1 is connected to the first terminal 51. The source electrode of the switching element Q1 is connected to the cathode of the first diode D1. The gate electrode of the switching element Q1 is connected to the anode of the first diode D1.

Furthermore, the rectifier circuit 50 has a second diode D2. The second diode D2 is connected in parallel with respect to the switching element Q1 so that a direction toward the first terminal 51 from the cathode of the first diode D1 is in a forward direction.

The anode of the second diode D2 is connected to the cathode of the first diode D and the source electrode of the switching element Q1. The cathode of the second diode D2 is connected to the drain electrode and the first terminal 51 of the switching element.

For the first diode D1, it is required that the forward voltage is low and the switching speed is fast.

The second diode D2 is required to have the pressure resistance.

For example, the first diode D1 is a schottky barrier diode. For example, the second diode D2 is a first recovery diode. A reverse recovery time of a general rectifier diode is about tens of µsec to 100 µsec, on the other hand, the reverse recovery time of the second diode D2 serving as the first recovery diode is shorter than that, for example, 100 nsec or less.

A threshold voltage of the gate electrode of the switching element Q1 is lower than the forward voltage of the first diode D1. A conductive saturation voltage of the switching element Q1 is lower than the forward voltage of the second diode D2.

For example, the rectifier circuit 50 of the embodiment can be used in a power source circuit.

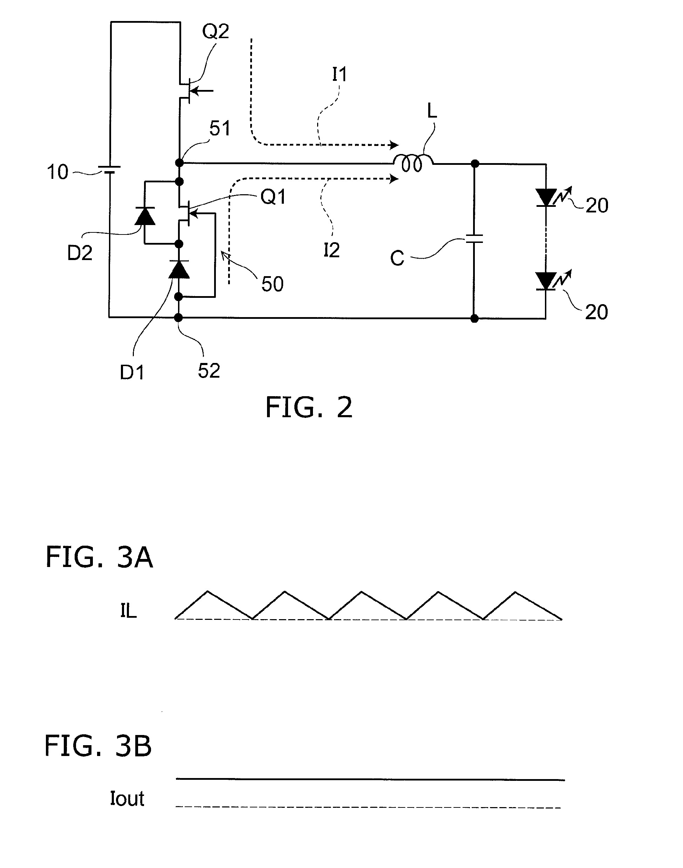

FIG. 2 is a circuit diagram of the power source circuit that uses the rectifier circuit 50 of the embodiment.

FIG. 2 illustrates a step-down type DC-DC converter (a back converter) as the power source circuit, as an example.

A high-side switching element Q2 connected to a direct power source 10 and the rectifier circuit 50 are alternately turned on/off, whereby a voltage lower than an input voltage from the direct power source 10 is output to a load.

For example, the load is a light emitting element 20. For example, the light emitting element 20 is a light emitting diode (LED). Furthermore, as the light emitting element 20, in addition to the LED, an organic light emitting diode (OLED), an inorganic electroluminescence light emitting element, an organic electroluminescence light emitting element, other electroluminescence type light emitting elements or the like can be used.

The first terminal 51 of the rectifier circuit 50 is connected to the source electrode of the high side switching element Q2. Furthermore, the first terminal 51 of the rectifier circuit 50 and the source electrode of the high side switching element Q2 are connected to one end of an inductor L.

The other end of the inductor L is connected to the output terminal of the back converter. A capacitor C for preventing the output voltage from greatly fluctuating in a short time is connected to the output terminal.

The gate electrode of the high side switching element Q2 is connected to a control circuit (not illustrated), and on/off of the high side switching element Q2 is controlled by a control signal from the control circuit.

Next, the operation of the power source circuit (the back converter) illustrated in FIG. 2 will be described referring to Figs. 3A and 3B.

Horizontal axes in FIGS. 3A and 3B show a time.

FIG. 3A shows an inductor electric current IL that flows through the inductor L.

FIG. 3B shows an electric current lout that is output to the load (the light emitting element 20).

When the high side switching element Q2 is turned on and the rectifier circuit 50 is turned off, an electric current I1 flows in the output terminal via the high side switching element Q2 and the inductor L from the direct power source 10. At this time, the inductor electric current IL increases and energy is accumulated in the inductor L.

Moreover, when the high side switching element Q2 is turned off, a regenerative electric current I2 flows in the output terminal via the rectifier circuit 50 and the inductor L by electromotive force due to the energy accumulated in the inductor L. The inductor electric current IL of this time becomes a decrease electric current that decreases with the time.

The high side switching element Q2 and the rectifier circuit 50 are alternately turned on and off, whereby an increase and a decrease of the inductor electric current IL are repeated, and the direct electric current Iₒᵤₜ obtained by averaging the inductor electric current IL is supplied to the light emitting element 20.

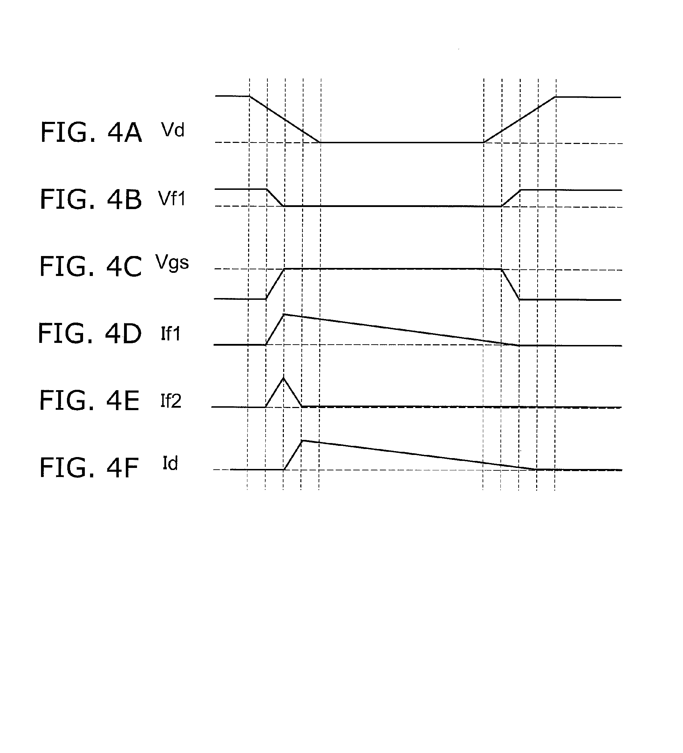

Next, the operation of the rectifier circuit 50 will be described referring to FIGS. 4A to 4F.

Horizontal axes in FIGS. 4A to 4F show a time.

FIG. 4 shows an electric potential Vd of a drain with respect to the source of the switching element Q1.

FIG. 4B shows an electric potential Vf1 of a cathode with respect to the anode of the first diode D1.

FIG. 4C shows an electric potential Vgs of the gate with respect to the source of the switching element Q1.

FIG. 4D shows a forward electric current If1 of the first diode D1.

FIG. 4E shows a forward electric current If2 of the second diode D2.

FIG. 4F shows an electric current Id flowing in the drain from the source of the switching element Q1.

When the high side switching element Q2 is turned off and electromotive force due to the energy accumulated in the inductor L is generated, the electric potential of the first terminal 51 is lowered compared to the electric potential of the second terminal 52.

Moreover, as illustrated in FIG. 4A, the drain electric potential Vd of the switching element Q1 begins to decrease. In addition, as shown in FIG. 4B, the cathode electric potential Vf1 of the first diode begins to decrease, and as illustrated in FIG. 4D, the forward electric current If1 begins to flow through the first diode D1. At this time, the forward voltage is applied to the second diode D2, and as illustrated in FIG. 4E, the forward electric current If2 also begins to flow through the second diode D2.

When the forward electric current If1 flows through the first diode D1, the forward voltage of the first diode D1 is applied between the gate and the source of the switching element Q1, and as illustrated in FIG. 4C, the gate electric potential Vgs of the switching element Q1 begins to rise. A threshold voltage of the gate electrode of the switching element Q1 is lower than the forward voltage of the first diode D1, and thus the switching element Q1 is turned to on.

At this time, in the circuit of the related art, since a parasitic capacitance Cgs between the gate and the source of the switching element Q1 and an electric discharge course of an electric charge accumulated in a junction capacitance of the first diode D1 are not included, there is a concern that the switching element Q1 is not turned on and a delay of turn-on occurs.

However, according to the embodiment, when the switching element Q1 is turned on, it is possible to cause the electric current to flow through the first terminal 51 via the first diode D1 and the second diode D2 from the second terminal 52. Thus, it is possible to discharge the electric charge accumulated in the parasitic capacitance Cgs between the gate and the source of the switching element Q1 and the conjunction capacitance of the first diode D1 via the second diode D2. Thereby, it is possible to turn the switching element Q1 on at a high speed.

When the switching element Q1 is turned on, as illustrated in FIG. 4F, the drain electric current Id begins to flow.

When the switching element Q1 is turned on, both terminals of the second diode D2 are connected between the drain and the source of the switching element Q1 and are short-circuited by the switching element Q1. Since the conductive saturation voltage of the switching element Q1 is lower than the forward voltage of the second diode D2, the second diode D2 is turned off.

Thus, the regenerative electric current I2 illustrated in FIG. 2 flows in the first terminal 51 via the first diode D1 and the switching element Q1 from the second terminal 52, and does not flow in the second diode D2.

Since the regenerative electric current I2 does not flow in the second diode D2, the electric charge is not accumulated in the second diode D2. For this reason, next, when the high side switching element Q2 is turned on and a reverse voltage is applied to the second diode D2, a recovery electric current flowing through the second diode D2 can be suppressed. Thus, the electric current loss due to the recovery electric current can be suppressed.

As the first diode D1, a schottky barrier diode is preferable in which the conduction loss is smaller than a diode of a PN junction and a PIN structure. Furthermore, in the schottky barrier diode, a reverse recovery time theoretically does not exist or is extremely short, and the switching speed thereof is higher than the diode of the PN conjunction and the PIN structure.

The second diode D2 is required to have a pressure resistance that is higher than that of the first diode D1. For that reason, for example, as the second diode D2, a first recovery diode is preferable which has the pressure resistance that is higher than schottky barrier diode.

The first recovery diode has a forward voltage higher than that of the schottky barrier diode, and the conduction loss thereof is great. However, according to the embodiment, the electric current (the regenerative electric current 12) flowing when the rectifier circuit 50 is turned on flows the first diode D1 serving as the schottky barrier diode with the low conduction loss and the switching element Q1 serving as the FET with the low on-resistance, and does not flow in the second diode D2. For this reason, the conduction loss due to the second diode D2 can be suppressed.

The second diode D2 having the pressure resistance higher than the first diode D1 and the switching element Q1 are in charge of the pressure resistance of the rectifier circuit 50.

In addition, when the voltage applied to the rectifier circuit 50 is relatively low, for example, 60 to 100 V, it is also possible to use the schottky barrier diode for both of the first diode D1 and the second diode D2.

According to the rectifier circuit 50 of the embodiment mentioned above, since the rectifier circuit can be turned on at a high speed without being influenced by the parasitic capacitance between the gate and the source of the switching element Q1, for example, the rectifier circuit is suitable for the application as a flywheel diode of a switching power source that performs the high-speed switching operation.

The voltage applied to each element of the rectifier circuit 50 is determined by the parasitic capacitance between the drain and the source of the switching element Q1, the parasitic capacitance between the gate and the source, the conjunction capacitance of the first diode D1, the conjunction capacitance of the second diode D2 or the like.

For example, in order to secure the pressure resistance of the gate electrode of the switching element Q1, Vd × (Cak2 / (Cak2 + Cgs + Cak1)) is set to be smaller than the threshold voltage Vth of the gate electrode of the switching element Q1.

Vd indicates the voltage applied between the first terminal 51 and the second terminal 52, Cgs indicates the parasitic capacitance between the gate electrode and the source electrode of the switching element Q1, Cak1 indicates the conjunction capacitance of the first diode D1, and Cak2 indicates the conjunction capacitance of the second diode D2.

The parasitic capacitance has a low degree of freedom of setting. Thus, in a rectifier circuit 50' illustrated in FIG. 1B, a capacitor C1 is connected between the gate electrode and the source electrode of the switching element Q1.

With the capacitance control of the capacitor C1, it is possible to design the rectifier circuit so that the application voltage to the gate electrode does not exceed the pressure resistance.

The rectifier circuit 50' illustrated in FIG. 1B is configured so that the capacitor C1 is added to the rectifier circuit 50 illustrated in FIG. 1A, and other configurations and the operations are the same as those of the rectifier circuit 50 of FIG 1A.

As described above, the capacitance between the gate and the source may become a cause that delays the turn-on of the switching element Q1. However, in the rectifier circuit 50' illustrated in FIG. 1B, when the switching element Q1 is turned on, the electric current also flows in the first terminal 51 via the first diode D1 and the second diode D2 from the second terminal 52. Accordingly, the electric charge accumulated in the capacitor C1 can be discharged via the second diode D2. Thereby, the switching element Q1 can be turned on at a high speed.

The rectifier circuits 50 and 50' of the above-mentioned embodiments can also be applied to other power source circuits other than the step-down type converter.

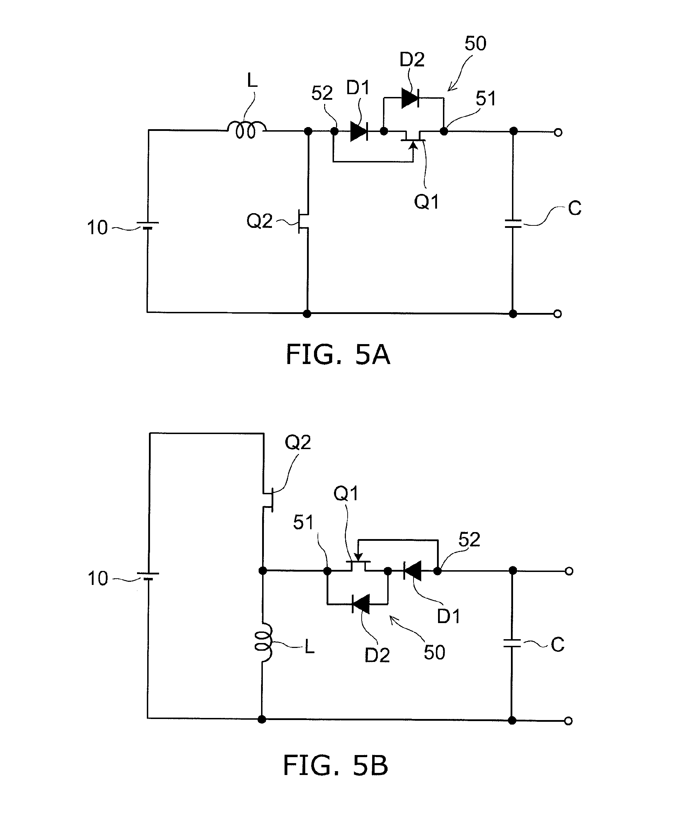

FIG. 5A is a circuit diagram of a step-up type converter (a boost converter) that uses the rectifier circuit 50.

The second terminal 52 of the rectifier circuit 50 is connected to the inductor L and the high side switching element Q2, and the first terminal 51 is connected to the output terminal of the boost converter.

When the high side switching element Q2 is turned on, the inductor L accumulates the energy by the electric current flowing in from the direct power source 10. When the high side switching element Q2 is turned off, the inductor L tries to maintain the electric current, discharges the accumulated energy and causes the electromotive force, and thus the electric current flows in the rectifier circuit 50. The energy from the inductor L is loaded on the input voltage, and the voltage, in which the input voltage increases, is output.

FIG. 5B is a circuit diagram of a step-up and step-down type converter (a buck booster converter) that uses the rectifier circuit 50.

The buck boost converter is a converter in which the direction of the rectifier circuit 50 is opposite that of the buck converter illustrated in FIG. 2, polarity of the output voltage is reversed, and both the voltage-up and the voltage-down is possible.

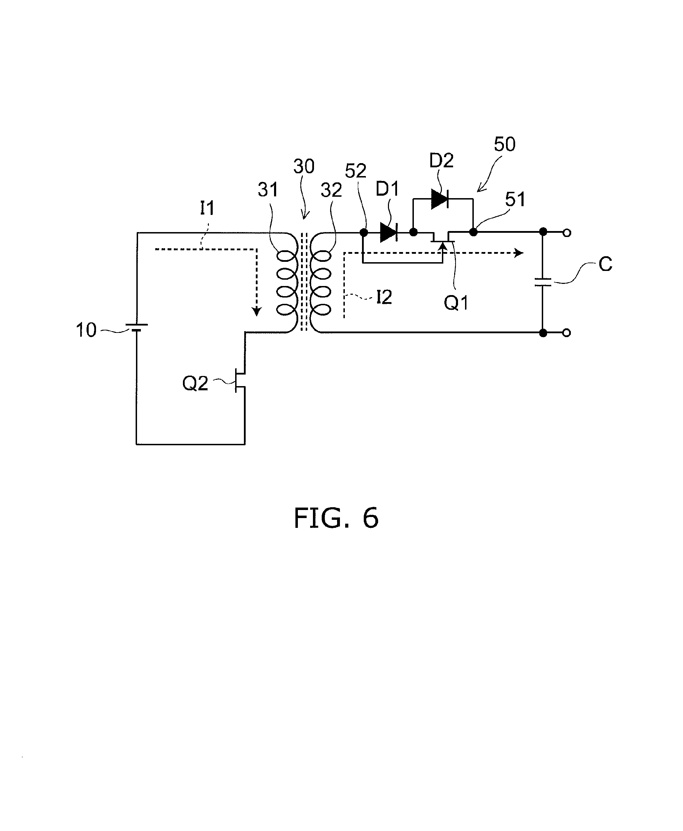

FIG. 6 is a circuit diagram of a fly back type converter that uses the rectifier circuit 50.

The fly back type converter is an insulation type DC-DC converter that uses a transformer 30. The transformer 30 has a core, and a primary coil 31 and a secondary coil 32 that are wound around the core.

When the switching element Q2 is turned on, the electric current I1 flows in the primary coil 31, and the core is magnetized due to a generated magnetic flux (the energy is accumulated). At this time, an induced electric current does not flow in the secondary coil 32 by the reversed rectifier circuit 50.

When the switching element Q2 is turned off, the energy accumulated in the core is emitted, and the electric current I2 flows through the rectifier circuit 50.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A rectifier circuit comprising:
a first diode (D1) connected between a first terminal (51) and a second terminal (52) so that a direction toward the first terminal (51) from the second terminal (52) is in a forward direction;
a switching element (Q1) including a first main electrode connected to the first terminal (51), a second main electrode connected to a cathode of the first diode (D1), and a gate electrode connected to an anode of the first diode (D1); and
a second diode (D2) connected in parallel with respect to the switching element (Q1) so that a direction toward the first terminal (51) from the cathode of the first diode (D1) is in a forward direction, between the first main electrode and the second main electrode of the switching element (Q1).

2. The rectifier circuit according to claim 1,
wherein, when the switching element (Q1) is turned on, an electric current flows through the second diode (D2), and after the switching element (Q1) is turned on, the electric current does not flow through the second diode (D2).

3. The rectifier circuit according to claim 1 or 2,
wherein a pressure resistance of the second diode (D2) is higher than a pressure resistance of the first diode (D1).

4. The rectifier circuit according to any one of claims 1 to 3,
wherein a conductive saturation voltage of the switching element (Q1) is lower than a forward voltage of the second diode (D2).

5. The rectifier circuit according to any one of claims 1 to 4, further comprising:
a capacitor (C1) connected between the gate electrode and the second main electrode of the switching element (Q1).
